# EUROPEAN PATENT SPECIFICATION

(11) **EP 4 312 371 B1**
(45) Date of publication and mention of the grant of the patent: **17.12.2025**
(21) Application number: 22186958.9
(22) Date of filing: 26.07.2022
(51) Int. Cl.: H02G 3/14, H03K 17/96, H02G 3/12

(54) **PARAMETRIZABLE, ILLUMINATION-SUPPORTED CONTROL ELEMENT, AND PARAMETRIZATION METHOD FOR AN ILLUMINATION-SUPPORTED CONTROL ELEMENT FOR BUILDING INSTALLATIONS**
PARAMETRISIERBARES BELEUCHTUNGSUNTERSTÜTZTES STEUERELEMENT UND PARAMETRIERUNGSVERFAHREN FÜR EIN BELEUCHTUNGSUNTERSTÜTZTES STEUERELEMENT FÜR GEBÄUDEINSTALLATIONEN
ÉLÉMENT DE COMMANDE PARAMÉTRABLE ASSISTÉ PAR L'ÉCLAIRAGE ET PROCÉDÉ DE PARAMÉTRAGE D'UN ÉLÉMENT DE COMMANDE ASSISTÉ PAR L'ÉCLAIRAGE POUR DES INSTALLATIONS DE CONSTRUCTION

(43) Date of publication of application: 31.01.2024
(73) Proprietor: ABB Schweiz AG, 5400 Baden (CH)
(72) Inventor: ZIERACH, Falk, 58762 Altena (DE); KEMPER, Jürgen, 59425 Unna (DE); WIESE, Michael, 42897 Remscheid (DE); KLOY, Olaf, 42389 Wuppertal (DE); KREUTZBERG, Steffen, 59174 Kamen (DE); DECKER, Jens, 51580 Reichshof (DE)
(74) Representative: Zimmermann & Partner Patentanwälte mbB

(56) References cited:
- EP-A1- 2 665 189
- WO-A1-2015/184530
- GB-A- 2 492 350
- US-A1- 2008 316 753
- US-A1- 2019 120 471
- US-B1- 6 396 007

## Description

### TECHNICAL FIELD

The disclosure generally relates to a parametrizable control element, and a parametrization method for a control element for building installations.

### BACKGROUND

Automation of building installations is advancing. In this context, manual control of building installations is increasingly replaced by electronic equivalents. The term building installations, as used herein, refers to installations of interior as well as exterior spaces, such as lightening, air conditioning, heating, (rolling) shutters, blinds, comfort scenes, windows, or gates. The number, as well as type of building installations may vary from space to space, as well as over the lifetime of a building, for instance, due to renovation. Therefore, a great number of different control elements, each control element partially reflecting the number of building installations in a space, may become necessary. In addition, modifications of building installation, for instance due to a renovation, may render already present control elements useless, thereby requiring their replacement. A single, more versatile control element which provides operating functions more flexibly may help to reduce resources of both, material and man hour.

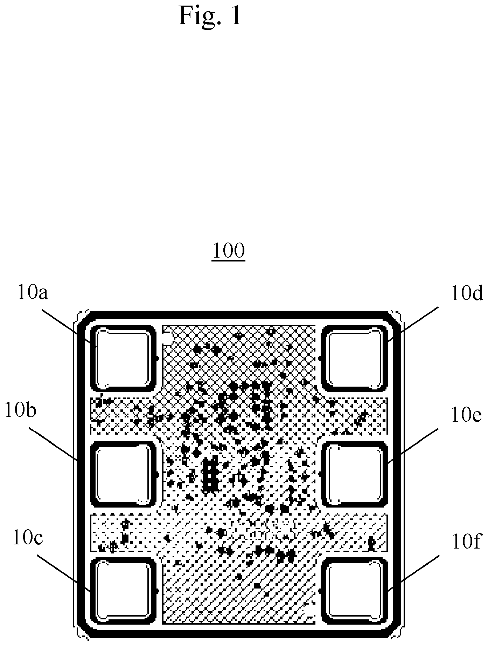

According to the conventional technology, for example, a control element is provided with a fixed number of operating elements. Examples of such control elements include, for instance, a one-fold, two- fold or multi- fold switch. Hardware permanently implements each of the fixed number of operating elements. Variants are typically realized via differences in electro-mechanics and/ or electronics between control elements. In electro-mechanics, variants are realized by a respective combination of individually pronounced pushbuttons, rockers or buttons. In electronics, variants are realized by a respective number of distinctive operating elements, as illustrated by Fig. 1.

Fig. 1 illustrates a schematic diagram of a control element according to prior art. The control element 100 provides six distinctive operating elements 10a - 10f. It may thus form the basis of a six-fold switch. The operation elements 10a - 10f are distinctively provided by a corresponding number of hardware components. The hardware components specify the number of operation elements 10a - 10f the control element 100 can provide. Not all of the operation elements 10a - 10f need to be used. The control element 100 may as well be implemented as a two-fold or four-fold switch by using only a corresponding number of the operation elements 10a - 10f. Each of the operation elements 10a - 10f may be used to control a building installation. For instance, operation element 10a may be used to control lightening, while operation element 10b may be used to control blinds.

In a space where more than six building installations are to be implemented and controlled, the control element 100 and its operation elements 10a - 10f are insufficient. It is, thus, favorable to provide a single, more versatile control element, thereby extending its usage time and application range.

EP 2 665 189 A1 discloses a capacitive control push-button panel for residential electrical series, which can be configured according to the electrical loads which are to be controlled. US 2008/316753 A1 discloses illumination means for articles where space is restricted, for example in connection with touch-sensitive display panels. GB 2 492 350 A discloses a lamp switch designed to control the on/off state of a lamp via touch sensing mode and provide backlight and brightness control functions in collaboration with LED indicators.

### SUMMARY OF THE DISCLOSURE

The scope of the invention is defined by the independent claims. Further advantageous embodiments of the invention are defined in the dependent claims.

In particular, according to an aspect, a parametrizable control element is provided.

Operation function, as used herein, may refer to a virtual representation of an operation element, such as a switch or a predefined input gesture by a user. The operation function serves as a flexible input interface that may be adjusted anytime by a respective parametrization using software code and/ or a parameter set. Thus, no hardware modifications are necessary for adjusting the control element. In some cases, one operation function may be used to control a single building installation, while, in other cases, a single operation function may be used to control a plurality of building installations. Although used interchangeably in some cases, operation function generally refers herein to a virtual representation of an operation element.

Parameterization, as used herein, may refer to a specification or configuration of the control element. The parametrization may be provided as software code and/ or a parameter set that is to be implemented by the control unit. The implementation may be facilitated by a program, an application and/ or dedicated tool, that is publicly and/ or commercially available, such as the ETS tool. Once the control element is parametrized, the capacitive area sensor virtually represents the operation elements.

The control signal may actuate one or more building installations or a specific function thereof. Examples include a control signal that causes a lamp to be switched on or off; brightness of a lamp to be increased or decreased; or a window to be opened or closed. In some cases, an operation function may define the control signal to also include a specific time to elapse before actuating a building installation. For example, an operation function may define that, actuating a building installation in 1 minute in response to a user input.

The parametrizable control element may further comprise, in some embodiments, a BUS interface. Alternatively, the BUS interface may be integrated into a flush-mounted insert. The BUS interface is configured to transmit the control signal to a control system of the at least one building installation. The BUS interface may be adapted to communicate via KNX bus. In some examples, the interface unit may be realized by the BUS interface. The control system of the building installation may refer, for instance, to a thermostat of a heating, or a motor control of blinds. A flush-mounted insert may also or alternatively include an actuator.

Alternatively, the parametrizable control element may comprise a wireless interface, such as a Bluetooth interface, that may serve as the interface unit and/ or for transmitting control signals to the building installations. In that case, the control element may be powered by a flush-mounted insert that it is connected to.

In embodiments, the parameterization further comprises a type of each of the at least one operation function and/ or an arrangement of the at least one operation function within the capacitive area sensor. The arrangement specifies where the at least one operation element to be virtually represented is located within the surface of the capacitive area sensor. The arrangement may consider the number of the operation functions such that a single operation function is arranged more centrally and extensively within the capacitive area sensor, while a plurality of operation functions is arranged in smaller scale within the capacitive area sensor. The arrangement may as well limit the surface of the capacitive area sensor to an active area. In cases where the parametrization specifies more than one operation function, the type of the operation functions may be the same or mutually different. Alternatively, the type of the operation functions may partially overlap such that some types of the operation functions are identical and some differ therefrom. The type of the operation functions may also be conditional for the arrangement of the operation functions. The operation functions may be represented by different sizes, as for instance, a predefined input gesture by a user may require more space than a simple pushbutton switch.

The capacitive area sensor may span the entire area of the control element. The dimensions of the control element or the dimensions of the capacitive area sensor may generally correspond to common frame-bound sizes of operating elements. In particular, the dimensions may correspond to any of 44 mm * 44 mm; 54 mm * 54 mm; 55 mm * 55 mm; or 63 mm * 63 mm. Depending on mechanical and/ or electrical requirements, the active surface of the operating element may correspond, for instance, to 46 mm * 44 mm for a printed circuit board assembly; or, for instance, to 44 mm * 42 mm for the capacitive area sensor.

Capacitive area sensor, as used herein, may refer to an electrically capacitive surface which can determine the position of one or more items or fingers on the surface or in the vicinity of the surface. In an embodiment, the capacitive area sensor is touch-sensitive which means that the capacitive area sensor is configured to detect one or more fingers on the surface. The capacitive area sensor may be configured to detect a touch and its location or an executed gesture on it. The capacitive area sensor may have a plurality of electrodes that are distributed in a regular pattern over the area of the capacitive sensor. The electrodes may allow for determining virtual keys or actuating fields. The electrodes of the capacitive area sensor may allow for configuring the control element according to a desired parametrization. For instance, the capacitive area sensor may be parametrized such that an individual virtual switch is represented. The capacitive area sensor may be parametrized without permanently defining the position the virtual switch. A parametrized one-fold switch may have another position than a parametrized two-fold switch. Both parametrization may be realized by embodiments.

In embodiments, the type of each of the at least one operation function comprises any of a pushbutton switch, a rocker switch, a wipe switch, a slider switch, a rotate switch, and a predefined input gesture by a user. In cases where more than one operation element is to be parameterized, the types of the operation elements may be mutually different. For instance, a first type of operation element is a rocker switch, while a second type of operation element is a pushbutton switch. In other cases, the types of the operation elements are identical or partially identical. As mentioned above, the virtual representation of the respective operation element may signify different sizes. For instance, a pushbutton switch may be represented by a smaller area than a predefined input gesture by a user. The type may thus also be conditional on the arrangement of each of the operation functions.

A predefined input gesture by a user, as used herein, refers to a parametrization which includes a operation function that is represented by a specific user gesture. Those user gestures may include, for instance, tapping the capacitive area sensor with the finger, double tapping the capacitive area sensor with two fingers, sliding two fingers on the capacitive area sensor up and/ or down, pitching on the capacitive area sensor with a user's thumb and pointer finger. The parametrization may assign a specific operation function to the gestures, respectively. For instance, increasing the brightness of a lamp may be assigned the gesture of pitching on the capacitive area sensor with a user's thumb and pointer finger.

In embodiments, the arrangement of the at least one operation element corresponds to a single-fold or multi-fold switch. In embodiments, the multi-fold arrangement may comprise any of the range of two-fold switch to ten-fold switch, in particular a four-fold switch. The multi-fold arrangement may correspond to a matrix layout of the capacitive area sensor with evenly sized operation functions. Alternatively, the multi-fold arrangement may correspond to a layout with unevenly sized operation functions, for instance when different types of operation functions are provided by the parametrization.

In embodiments, the parameterization may be used to determine whether the operation function represents a key, or rocker switch. As specific examples, the following parametrizations are conceivable:
For a parametrization of pushbutton switches that may be arranged in a one- to four-fold manner, the touch and its position may be detected by one of the actuating fields or keys of the capacitive area sensor and an associated control signal is provided. To avoid unintentional simultaneous triggering of two or more keys, blocking areas may be defined between the virtual pushbuttons. Touches detected in these areas may be ignored. The area of keys plus the area of the blocking areas may sum up to the capacitive area sensor. In addition, the necessary touch duration for actuating an operation by the virtual pushbutton may also be set by the parametrization.

For the parametrization of rocker switches that may be arranged in a one- to two-fold manner, two actuating fields or keys may be combined to form a rocker switch. The resulting rocker switch may be horizontally or vertically arranged and may be used, for example, to activate a function via one side and deactivate it via the other side of the rocker switch. Also in this case, the individual rockers may be separated from each other via virtual blocking areas. A required touch duration may also be set.

A parametrization of a wipe/slider function arranged in a one- to two- fold manner may not only detect the touch and its location, but also the gesture performed by a user's finger. Such gestures may include upwards or downwards movement of the user's finger or a specific movement and distance traveled on the capacitive area sensor. Such gestures may be converted into a control signal by the control unit to actuate a building installation, for instance to activate or deactivate it. In addition, or alternatively, such gestures may be converted, by the control unit, to a control signal that causes dimming a building installation. Another parametrization may provide operation functions which represent two parallel sliders.

A parametrization of a rotate function may be implemented by using the entire surface of the capacitive area sensor. The direction of rotation and the swept angle may be detected in a manner comparable to that of a rotary knob. This makes it possible, for example, to implement a dimming function similar to wiping, but without being limited in terms of the duration of dimming or the distance covered. Accordingly, this configuration is particularly suitable for relative dimming, i.e., increasing a value by x steps, whereby the step size can be set via the parametrization.

In addition, mixed arrangements of operation functions may also be possible, e.g., a vertical slider on the left-hand side and two individual buttons on the right-hand side of the capacitive area sensor.

In embodiments, a design cover is detachably connected to the control element and is configured to optically represent the parametrized operation element. The design cover may be the control element's top cover which a user touches. The design cover may be configured in a way to avoid attenuation of the user input. The design cover may be made from insulating material which allows capacitive capturing of inputs. In some cases, the design cover may be formed of glass, wood, or plastics. In some embodiments, the design cover comprises a printable surface. The printable surface may be permanently printed by an inkjet or laser printer such that the print remains visible despite frequent usage or weather exposure of the control element. The tool or application may provide for launching an automatic print job for printing the design cover or an automatic shopping order for ordering a respective design cover, for instance, in an online store. A third-party supplier may retrieve print information from the tool. The tool may be reached via the website of the control element supplier or via the website of a third-party supplier. Alternatively, the design cover may be designed by a separate labeling tool, for instance a specific web application.

The parametrizable control element further comprises a plurality of light-emitting diodes (LEDs), and a light guide optically coupled to the plurality of LEDs. The logic unit may be configured to control each of the plurality of LEDs according to the parametrization of the capacitive area sensor. This can mean, for instance, that if the parametrization of the capacitive area sensor provides for a single operation function, the plurality of LEDs can be controlled such that only a single LEDs is operated. Otherwise, the plurality of LED may be segmented according to the number of operation functions and controlled in a segmented manner. Alternatively, the plurality of LEDs or a part of the plurality of LEDs is controlled in a concerted manner.

The logic unit may be further configured to control each of the of LEDs according to external conditions. Alternatively, the logic unit may be further configured to control each of the plurality of LEDs according to the control signal.

In particular embodiments, the plurality of the LED may be controlled according to the concept of orientation lighting, status lighting, optical operator feedback, or optical animation.

The concept of orientation illumination may represent an adjustable, single-color illumination that is independent of the parametrization of the control element, the operating function, or any control signal. Rather, the brightness of the LEDs can be varied depending on external conditions. As an example, orientation illumination may switch from high brightness to low brightness, or vice versa, at the transition from day to night mode.

The concept of status illumination may be used to visually represent the status or current operation mode of the operation function. This makes it possible, for example, to visualize the switching status of a lamp via different color assignments and/ or brightness directly on the control element. For example, the on state of said lamp may be represented by the color red and the off state by the color green. Depending on how many functions are parameterized on the capacitive area sensor, for example 1-fold or 4-fold, several segments of LEDs may be combined. This concept is particularly suitable for operating functions which represent key switches or rocker switches.

The concept of optical operator feedback may visually indicate that a user input to the operation function has been detected. For instance, if the capacitive area sensor is parametrized as a key switch which is arranged at the left-hand side of the capacitive area sensor, and a user input has been detected to the represented key switch, the corresponding LED segments may flash or darken briefly. Afterwards, the LEDs may be controlled according to the concept of orientation or status illumination.

The concept of animation function may visually support an executed operation function. Segments of the LEDs are controlled according to the control signal of an operation function. The animation function may assign any color to the LEDs. After completion of an animation, the LEDs may be controlled according to the concept of orientation or status illumination. For instance, in the case of a swipe switch or a swipe gesture that is implemented as a predefined input gesture by a user, the four LEDs on one side are switched on or off in such a way that the current set size (0 - 100%) is visualized in 25% steps according to the four LEDs per side. In case of operation functions that are active longer than the detected touch input by the user, e.g. the movement time of a blind, the animation function may be repeated until the time required to achieve the stored function has elapsed.

The arrangement of the rotation function may be a full-surface operation function meaning that the entire surface of the capacitive area sensor may represent the rotation function. In this specific case, the light guides on both sides are available for visual support of the animation function, for example, for adjusting the setpoint of the room temperature. A counter-clockwise operation may be displayed as a setpoint reduction, e.g. in blue, and a clockwise operation may be displayed as a setpoint increase, e.g. in red. The current level of adjustment may be visualized analogously to the wipe gesture by switching individual LEDs on or off. This concept of animation function may be particularly suitable for parametrizations which implement a wipe or slide switch or rotate switch.

The plurality of LEDs may comprise RGB LEDs, enabling the control element to represent a range of optical signals with a single LED.

The parametrizable control element comprises a printable circuit board (PCB). The capacitive area sensor may be arranged at a first side of the PCB, while the plurality of LEDs may be arranged at a second side of the PCB, the second side being opposite of the first side.

The light guide may be laterally arranged at the PCB. Also, electronics for touch detection may be laterally arranged at the PCB. The light guide may be optimized for homogeneous light distribution and may be made of translucid plastics which allow for optimal color mixing. The light guide may be elongated. In some embodiments, the light guide is segmented. In other embodiments, the light guide is formed of individual pieces of light guides. A piece of a light guide may be optically coupled to one or several LEDs. In embodiments, the piece of a light guide may be optically coupled to two LEDs. The light guide may be arranged at opposite sides of the PCB. Alternatively, the light guide may surround the PCB on all of its four sides.

The parametrizable control element further comprises a sensor base. The sensor base is configured to accommodate the printed circuit board at a first side, wherein the light guide protrudes in a gap between the design cover and the sensor base of the control element. The sensor base comprises a clamping arrangement at a second side that is configured to fasten the control element on a flush-mounted insert.

In embodiments, the design cover comprises at least one recess. The light guide may be arranged in the at least one recess. In addition or alternatively, there may be at least one transparent light window in the design cover. The light guide may be optically coupled to the transparent light window. The recess or the transparent light window may be strip-shaped or elongated. The recess or the transparent light window may be laterally arranged within the design cover. This allows for optimal visual operating feedback that is visible, even when the user's finger or hand covers much of the control element.

According to embodiments, the design cover and the sensor base are connected such that the control element is sealed. The sealing may prevent water or other environmental influences from entering into the control element.

In embodiments, the sensor base comprises one or more metal springs. One metal spring may be configured to fasten the sensor base of the control element with a flush-mounted insert. In embodiments, one metal spring may be a catch spring. The metal spring may comprise barbs and may be configured to be inserted and latched into a flush-mounted insert to prevent unauthorized removal of the control element from the flush-mounted insert.

In embodiments, the flush-mounted insert comprises above-described metal spring and the sensor base has recesses to accommodate the metal spring or parts thereof.

### BRIEF DESCRIPTION OF THE DRAWINGS

Fig. 1 illustrates a schematic diagram of a PCBA of a control element according to prior art;
Fig. 2 illustrates a schematic side view of a parametrizable control element according to an example useful to understand the invention that is not explicitly claimed as such.
Fig. 3 illustrates a schematic diagram of parametrizable control element according to an embodiment;
Fig. 4 illustrates a schematic diagram of a first side of a printable circuit board according to embodiments described herein.
Fig. 5 illustrates a schematic diagram of a second side of a printable circuit board according to embodiments described herein
Fig. 6a and 6b illustrate schematic diagrams of a parametrizable control element according to a further embodiment;
Fig. 7 illustrates a switching assembly according to an embodiment;
Fig. 8 illustrates a schematic diagram of parametrizable control element according to an example useful to understand the invention that is not explicitly claimed as such;
Fig. 9a - 9c illustrate schematic diagrams of a switching assembly according to an embodiment;
Fig. 10 illustrates a schematic diagram of a parametrization method for a control element according to an embodiment.

### DESCRIPTION OF EMBODIMENTS

In the following, embodiments are set forth to describe specific examples presented herein. The person skilled in the art will recognize that one or more other examples and/ or variations of these examples may be practiced without all the specific details outlined below. Also, well known features may not be described in detail so as not to obscure the description of the examples herein. For the ease of illustration, like reference numerals are used in different figures to refer to the same elements or additional instances of the same element. Features illustrated or described as part of one embodiment can be used on or in conjugation with any other embodiment to yield yet a further embodiment.

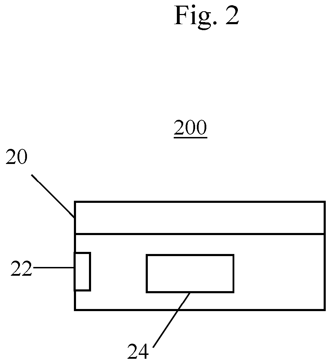

Referring now to the drawings, Fig. 2 presents a side view of a parametrizable control element 200 for controlling at least one building installation by a user according to an example useful to understand the invention that is not explicitly claimed as such. The control element 200 has a capacitive area sensor 20. The capacitive area sensor 20 may span the entire surface of the control element 200. The control element 200 further has an interface unit 22. The interface unit 22 serves to receive input, such as a parametrization for the capacitive area sensor 20. A logic unit 24 of the control element 200 serves to parametrize the capacitive area sensor 20 according to a received parametrization such that the capacitive area sensor 20 represents the one or more operation elements provided by the parametrization. The logic unit 24 also serves to convert a user input to the one or more operation function into a control signal for at least one building installation.

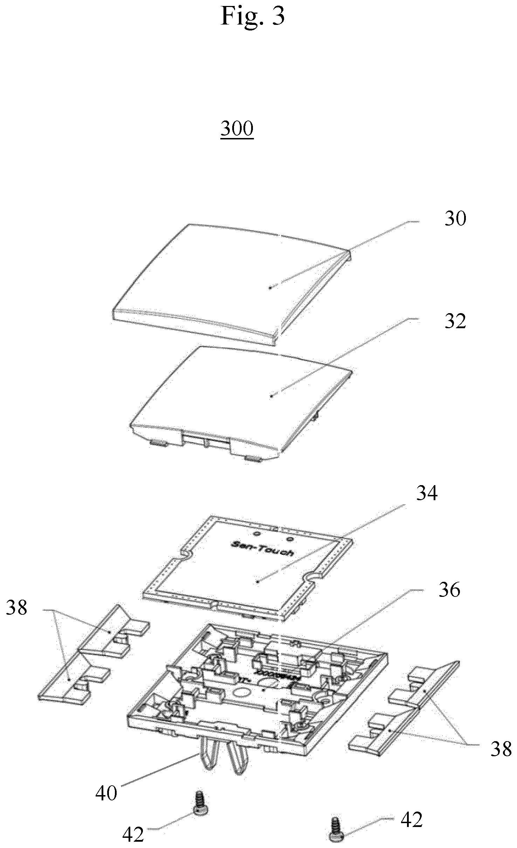

Fig. 3 illustrates a schematic diagram of parametrizable control element 300 according to an embodiment. The control element is presented in an exploded manner. The control element 300 can have a design cover 30, which is arranged at the top outer side of the control element 300 and can be in contact with the environment or potential users of the control element 300. The printable surface of the design cover 30 may optically reflect the parametrized operation element (not shown) to instruct a user on how to use the control element 300. Next, an technical cover 32 may be included in the control element 300. The technical cover 32 may be the outer cover of the control element. It may serve to accommodate the design cover 30 and to connect it with the printable circuit board, PCB, 34 which, in some cases, carries the capacitive area sensor on one side, and a plurality of LED at the other side, the other side facing downward in this Fig. As shown, the capacitive area sensor may span the entire surface of the PCB 34 which corresponds to the area of the control element 300.

When assembled, the sensor base 36 may accommodate the PCB 34 and light guides 38 may be sandwiched between the sensor base 36 and the PCB 34 such that an edge of the light guides 38 protrudes from the assembled control element 300. Although depicted as four separate light guides 38 that are arranged on opposite sides of the control element 200, the number as well as the arrangement of the light guides 38 may deviate therefrom. An edge of the light guide 38 may surround the assembled control element 300 on all of its four sides, in some examples. A clamping arrangement 40 can be provided at the side of the sensor base 36 opposite to the side accommodating the PCBA 34. The clamping arrangement 40 may serve to fasten the control element 300 at a flush-mounted insert (not shown) and may serve as an electro-mechanical interface in connection with the flush-mounted insert. The control element 300 can be assembled by screws 42 and mounted, in its assembled form, to a flush-mounted insert.

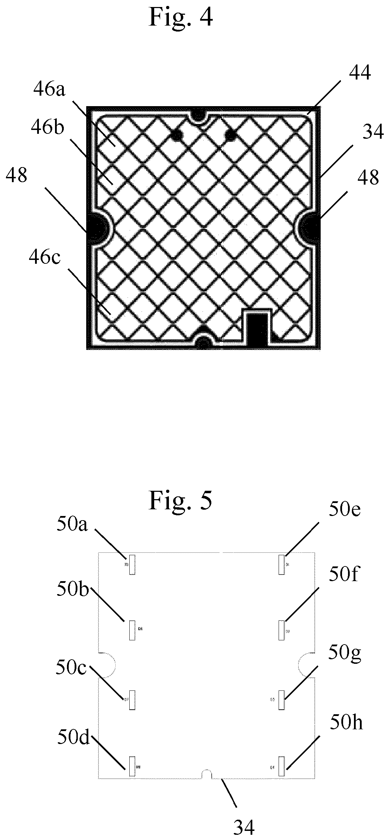

Fig. 4 illustrates a schematic diagram of a top side of the PCB 34 according to an embodiment. This side of the PCB 34 may carry the capacitive area sensor 44. When the control element is in use, the top side of the PCB 34 may face towards a potential user or the environment. As illustrated, the capacitive area sensor 44 may have individual electrodes, which may be arranged in a matrix. The electrodes are here exemplarily referred to as 46a, 46b, 46c. The number of individual electrodes may deviate from the one illustrated. The electrodes may be connected to a microcontroller which evaluates a user's touch and its position captured by the electrodes. Side recesses 48 may serve to assemble the PCBA 34 within the control element 300.

Fig. 5 illustrates a schematic diagram of a bottom side of a PCBA 34 according to embodiments described herein. When the control element is in use, the bottom side of the PCBA may face towards a wall or arrangement the control element 300 is fastened to. A plurality of LEDs 50a ... 50h may be disposed at the bottom side of the PCBA. Each of the plurality of LEDs may be individually controllable. The LEDs may be optically coupled to a light guide (not shown). In some examples, two LEDs are coupled to one light guide, whereby any other ratio is possible as well.

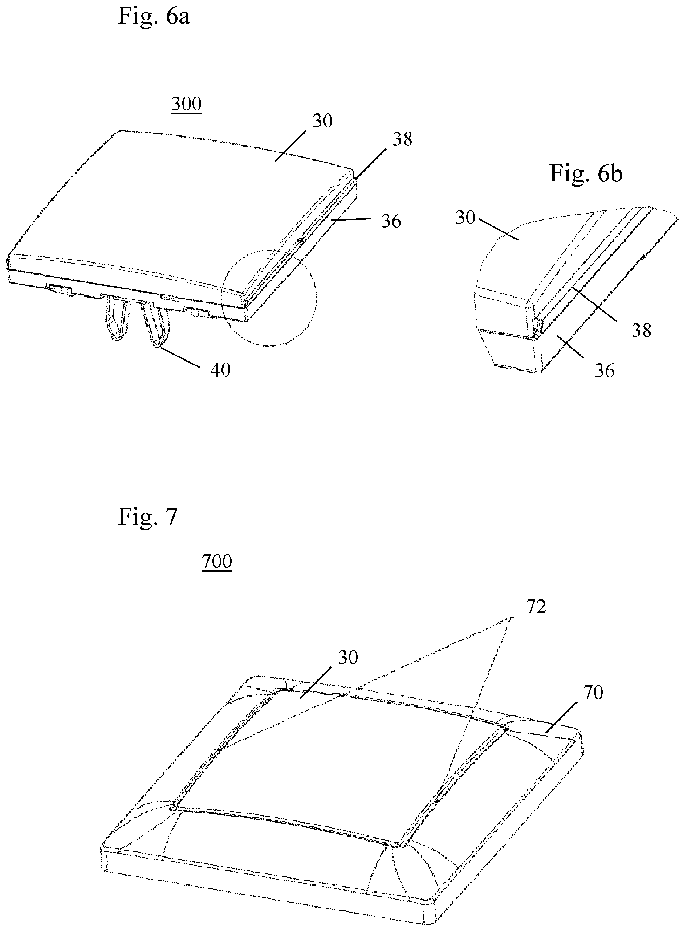

Fig. 6a illustrates a schematic diagram of parametrizable control element 300 according to a further embodiment. Therein, the control element 300 is depicted in assembled form. In assembled form, the outside elements of the control element 300 are visible. The latter may include, in particular, the design cover 30, the sensor base 36, and the light guide 38 which may be sandwiched between the design cover 30 and the sensor base 36. Also, the clamping arrangement 40 for fastening the control element 300 to a flush-mounted inset is depicted in Fig. 6a. In Fig. 6b, a magnification of the lower right side of the control element 300 is depicted. As can be seen therefrom, the light guide 38 may protrude from the assembled control element 300, the edges of the design cover 30 and the sensor base 36 forming one plane.

Fig. 7 illustrates a switching assembly 700 according to an embodiment. Above-discussed control element 300 may form part of the switching assembly 700, as well as a frame 70. The frame 70 accommodates the control element such that the control element's design cover 30 may be exposed and may be touched by a user's finger. The switching assembly 700 may provide for an accommodation of the control element which leaves a gap 72 for the light guides to illuminate, and ultimately to reach the user's eye.

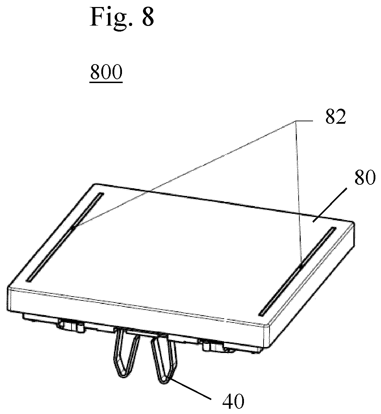

Referring now to Fig. 8 which illustrates a schematic diagram of parametrizable control element 800 of an example useful to understand the invention that is not explicitly claimed as such. The control element 800 also may have above-discussed clamping arrangement for fastening the control element 800 to a flush-mounted insert. The design cover 80 of the control element 800, however, may differ from above-discussed control elements in that two lateral recesses 82 are provided within the design cover 80. The lateral recesses 82 or windows 82 are to be illuminated by the light guides (not shown).

Although not specifically depicted, the skilled person understands that the control element 800 and/ or features thereof may be combined with any other embodiments described herein or features thereof. For instance, the control element 800 may also form part of a switching assembly with a corresponding frame. In this case, no illuminated gap would be provided, as the light of the LEDs is emitted trough the surface of the control element 800. As another example, the control element 800 may as well have discussed metal spring.

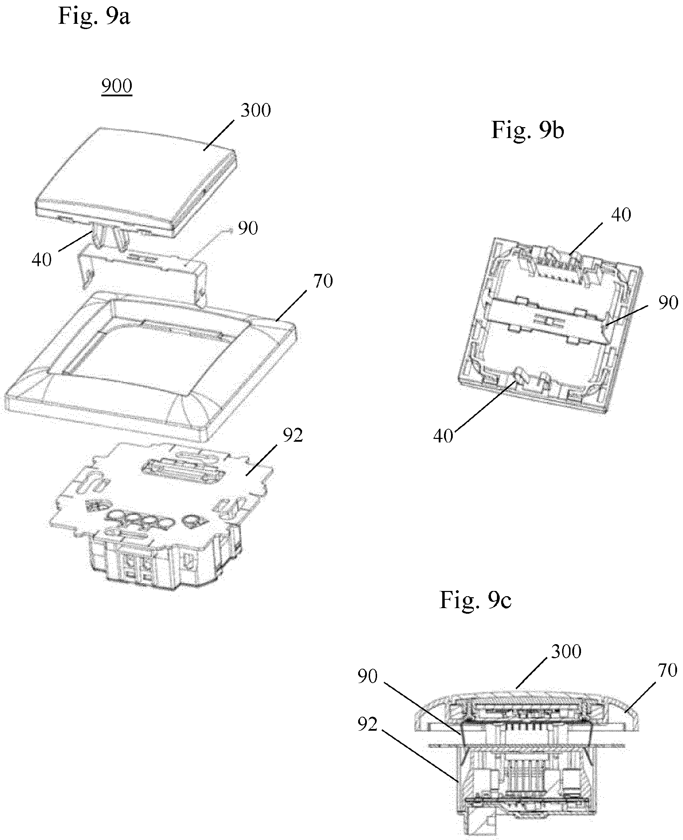

Fig. 9a - 9c present different perspectives of a switching assembly according to embodiments. In Fig. 9a, which illustrates an exploded view of switching assembly 900, the control element 300 with the latching arrangement 40 may be configured to engage with the flush-mounted inset 92. The latching arrangement 40 may serve as a electro-mechanical interface to the flush-mounted inset 92. A flush-mounted insert may serve for voltage supply of the control element and may provide further electronics and/ or mechanics to directly control building installations, for instance by a relay or a BUS system. The flush-mounted insert 92 (not belonging to switching assembly 900) may also provide recesses to accommodate the protruding parts of the metal spring 90. The metal spring may have barbs on its protruding parts which prevent unauthorized removal of the control element 300 from the flush-mounted insert 92. The frame 70 may accommodate the control element 300.

Fig. 9b illustrates a schematic bottom perspective of the switching assembly 900. When in use, this side may face the flush-mounted inset 92. As shown, the switching assembly may have two latching arrangements 40 which are laterally arranged, although this number may vary in embodiments. The latching arrangements 40 may be clamping springs to clamp the operating elements to the flush-mounted insert. The metal spring 90 may be arranged centrally on the control element.

Lastly, Fig. 9c shows a side view of the switching assembly 900 when the control element 300 is latched to the flush-mounted insert 92. In this case, the barbs of the metal spring 90 may be fastened to a respective recess of the flush-mounted insert 92, thereby impeding or preventing unallowed removal of the control element 300 from the flush-mounted insert 92.

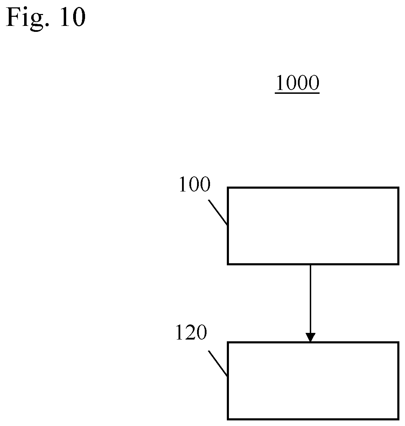

Referring now to Fig. 10 which illustrates a schematic diagram of a parametrization method 1000 for a control element according to an embodiment. The method 1000 provides for receiving 100, by the user interface a parameterization for the capacitive area sensor, the parametrization comprising at least one operation function. The method 1000 further provides for parametrizing 120, by the logic unit, the capacitive area sensor according to the parameterization such that the capacitive area sensor is configured to detect a user input to the at least one operation element and the logic unit is further configured to convert the user input to the at least one operation element into a control signal for the at least one building installation.

Embodiments and/ or features described herein with respect to the parametrization method may be implemented equally within the control element and vice versa.

## Claims

1. A parametrizable control element (300) configured to control at least one building installation by a user, the control element comprising:
- a capacitive area sensor (20, 44);
- an interface unit (22) configured to receive a parameterization for the capacitive area sensor, the parametrization comprising at least one operation function;
- a logic unit (24) configured to parametrize the capacitive area sensor according to the parameterization;
wherein, when parametrized according to the parameterization, the capacitive area sensor is configured to detect a user input to the at least one operation function; and wherein the logic unit is configured to convert the user input to the at least one operation function into a control signal for the at least one building installation;
further comprising
- a plurality of light-emitting diodes, LEDs (50a-h);
- a light guide (38) optically coupled to the plurality of LEDs;
wherein the logic unit is further configured to control each of the plurality of LEDs according to the parametrization of the capacitive area sensor and/ or according to the control signal, further comprising a printable circuit board, PCBA, (34) wherein the capacitive area sensor is arranged at a first side of the PCBA, wherein the plurality of LEDs is arranged laterally at a second side of the PCBA, further comprising a sensor base (36) and a design cover (30), wherein the sensor base is configured to accommodate the PCBA at a first side, wherein the light guide protrudes in a gap between the design cover and the sensor base of the control element.

2. The parametrizable control element according to claim 1, further comprising a BUS interface configured to transmit the control signal to a control system of the at least one building installation.

3. The parametrizable control element according to any of the preceding claims, wherein the capacitive area sensor spans the almost entire area of the control element.

4. The parametrizable control element according to any of the preceding claims, wherein the capacitive area sensor is touch-sensitive.

5. The parametrizable control element according to any of the preceding claims, the parameterization further comprising a type of the at least one operation function and/ or an arrangement of the at least one operation function within the capacitive area sensor.

6. The parametrizable control element according to the preceding claim, wherein the type of the at least one operation function comprises a virtual representation of an electro-mechanical switch or a predefined input gesture by a user.

7. The parametrizable control element according to claim 5 or 6, wherein the arrangement of the at least one operation function corresponds to a single-fold or multi-fold switch.

8. The parametrizable control element according to any of the preceding claims, wherein the design cover is detachably connected to the control element.

9. The parametrizable control element according to any of the preceding claims, further comprising a metal spring, wherein the metal spring is configured to fasten the control element to a flush-mounted insert, wherein the metal spring comprises barbs and is configured to prevent removal of the control element from the flush-mounted insert.

10. A switching assembly, comprising:
- the parametrizable control element according to any of the preceding claims ;
- a frame configured to accommodate the parametrizable control element such that a gap between the parametrizable control element and the frame is configured to be illuminated by the light guide.

11. Parametrization method to parametrize a control element (300) according to any of the claims 1 - 9, the method comprising:
- receiving, by the user interface, a parameterization for the capacitive area sensor, the parametrization comprising at least one operation function;
- parametrizing, by the logic unit, the capacitive area sensor according to the parameterization such that the capacitive area sensor is configured to detect a user input to the at least one operation function and the logic unit is configured to convert the user input to the at least one operation function into a control signal for the at least one building installation.

## Patentansprüche

1. Parametrisierbares Steuerelement (300), das dazu ausgelegt ist, mindestens eine Gebäudeinstallation durch einen Benutzer zu steuern, wobei das Steuerelement umfasst:
- einen kapazitiven Flächensensor (20, 44);
- eine Schnittstelleneinheit (22), die dazu ausgelegt ist, eine Parametrisierung für den kapazitiven Flächensensor zu empfangen, wobei die Parametrisierung mindestens eine Betriebsfunktion umfasst;
- eine Logikeinheit (24), die dazu ausgelegt ist, den kapazitiven Flächensensor gemäß der Parametrisierung zu parametrisieren;
wobei der kapazitive Flächensensor, wenn gemäß der Parametrisierung parametrisiert, dazu ausgelegt ist, eine Benutzereingabe in die mindestens eine Betriebsfunktion zu detektieren; und
wobei die Logikeinheit dazu ausgelegt ist, die Benutzereingabe in die mindestens eine Betriebsfunktion in ein Steuersignal für die mindestens eine Gebäudeinstallation umzuwandeln;
ferner umfassend
- eine Vielzahl von Leuchtdioden, LEDs, (50a-h);
- einen Lichtleiter (38), der optisch mit der Vielzahl von LEDs gekoppelt ist;
wobei die Logikeinheit ferner dazu ausgelegt ist, jede der Vielzahl von LEDs gemäß der Parametrisierung des kapazitiven Flächensensors und/oder gemäß dem Steuersignal zu steuern;
ferner umfassend eine druckbare Leiterplatte, PCBA, (34), wobei der kapazitive Flächensensor an einer ersten Seite der PCBA angeordnet ist, wobei die Vielzahl von LEDs lateral an einer zweiten Seite der PCBA angeordnet ist, ferner umfassend eine Sensorbasis (36) und eine Designabdeckung (30),
wobei die Sensorbasis dazu ausgelegt ist, die PCBA an einer ersten Seite unterzubringen, wobei der Lichtleiter in einem Spalt zwischen der Designabdeckung und der Sensorbasis des Steuerelements vorsteht.

2. Parametrisierbares Steuerelement nach Anspruch 1, ferner umfassend eine BUS-Schnittstelle, die dazu ausgelegt ist, das Steuersignal an ein Steuersystem der mindestens einen Gebäudeinstallation zu übertragen.

3. Parametrisierbares Steuerelement nach einem der vorhergehenden Ansprüche, wobei der kapazitive Flächensensor nahezu die gesamte Fläche des Steuerelements überspannt.

4. Parametrisierbares Steuerelement nach einem der vorhergehenden Ansprüche, wobei der kapazitive Flächensensor berührungsempfindlich ist.

5. Parametrisierbares Steuerelement nach einem der vorhergehenden Ansprüche, wobei die Parametrisierung ferner einen Typ der mindestens einen Betriebsfunktion und/oder eine Anordnung der mindestens einen Betriebsfunktion innerhalb des kapazitiven Flächensensors umfasst.

6. Parametrisierbares Steuerelement nach dem vorhergehenden Anspruch, wobei der Typ der mindestens einen Betriebsfunktion eine virtuelle Darstellung eines elektromechanischen Schalters oder eine vordefinierte Eingabegeste durch einen Benutzer umfasst.

7. Parametrisierbares Steuerelement nach Anspruch 5 oder 6, wobei die Anordnung der mindestens einen Betriebsfunktion einem einfachen oder mehrfachen Schalter entspricht.

8. Parametrisierbares Steuerelement nach einem der vorhergehenden Ansprüche, wobei die Designabdeckung abnehmbar mit dem Steuerelement verbunden ist.

9. Parametrisierbares Steuerelement nach einem der vorhergehenden Ansprüche, ferner umfassend eine Metallfeder, wobei die Metallfeder dazu ausgelegt ist, das Steuerelement an einem bündig montierten Einsatz zu befestigen, wobei die Metallfeder Widerhaken umfasst und dazu ausgelegt ist, Entfernen des Steuerelements von dem bündig montierten Einsatz zu verhindern.

10. Schaltanordnung, umfassend:
- das parametrisierbare Steuerelement nach einem der vorhergehenden Ansprüche;
- einen Rahmen, der dazu ausgelegt ist, das parametrisierbare Steuerelement so unterzubringen, dass konfigurationsgemäß ein Spalt zwischen dem parametrisierbaren Steuerelement und dem Rahmen durch den Lichtleiter beleuchtet wird.

11. Parametrisierungsverfahren zum Parametrisieren eines Steuerelements (300) nach einem der Ansprüche 1-9, wobei das Verfahren umfasst:
- Empfangen einer Parametrisierung für den kapazitiven Flächensensor durch die Benutzerschnittstelle, wobei die Parametrisierung mindestens eine Betriebsfunktion umfasst;
- Parametrieren des kapazitiven Flächensensors gemäß der Parametrisierung durch die Logikeinheit, sodass der kapazitive Flächensensor dazu ausgelegt ist, eine Benutzereingabe in die mindestens eine Betriebsfunktion zu detektieren, und die Logikeinheit dazu ausgelegt ist, die Benutzereingabe in die mindestens eine Betriebsfunktion in ein Steuersignal für die mindestens eine Gebäudeinstallation umzuwandeln.

## Revendications

1. Élément de commande paramétrable (300) configuré pour commander au moins une installation de bâtiment par un utilisateur, l'élément de commande comprenant :
- un capteur de surface capacitif (20, 44),
- une unité d'interface (22) configurée pour recevoir un paramétrage du capteur de surface capacitif, le paramétrage comprenant au moins une fonction d'opération ;
- une unité logique (24) configurée pour paramétrer le capteur de surface capacitif en fonction du paramétrage ;
lorsque paramétré selon le paramétrage, le capteur de surface capacitif étant configuré pour détecter une entrée utilisateur dans l'au moins une fonction d'opération ; et
l'unité logique étant configurée pour convertir l'entrée d'utilisateur vers l'au moins une fonction d'opération en un signal de commande pour l'au moins une installation de bâtiment ;
comprenant en outre
- une pluralité de diodes électroluminescentes, LED (50a-h) ;
- un guide de lumière (38) couplé optiquement à la pluralité de LED ;
l'unité logique étant en outre configurée pour commander chacune de la pluralité de LED en fonction du paramétrage du capteur de surface capacitif et/ ou en fonction du signal de commande,
comprenant en outre une carte de circuit imprimé, PCBA, (34)
le capteur de surface capacitif étant agencé sur un premier côté du PCBA, la pluralité de LED étant agencée latéralement sur un deuxième côté du PCBA,
comprenant en outre une base de capteur (36) et un couvercle de conception (30),
la base de capteur étant configurée pour recevoir la carte PCBA au niveau d'un premier côté, le guide de lumière faisant saillie dans un espace entre le couvercle de conception et la base de capteur de l'élément de commande.

2. Élément de commande paramétrable selon la revendication 1, comprenant en outre une interface de BUS configurée pour transmettre le signal de commande à un système de commande de l'au moins une installation de bâtiment.

3. Élément de commande paramétrable selon l'une quelconque des revendications précédentes, le capteur de surface capacitif couvrant presque toute la surface de l'élément de commande.

4. Élément de commande paramétrable selon l'une quelconque des revendications précédentes, le capteur de surface capacitif étant tactile.

5. Élément de commande paramétrable selon l'une quelconque des revendications précédentes, le paramétrage comprenant en outre un type de l'au moins une fonction d'opération et/ou un agencement de l'au moins une fonction d'opération à l'intérieur du capteur de surface capacitif.

6. Élément de commande paramétrable selon la revendication précédente, le type de l'au moins une fonction d'opération comprenant une représentation virtuelle d'un interrupteur électromécanique ou d'un geste d'entrée prédéfini par un utilisateur.

7. Élément de commande paramétrable selon la revendication 5 ou 6, l'agencement de l'au moins une fonction d'opération correspondant à un commutateur à pliage unique ou multiple.

8. Élément de commande paramétrable selon l'une quelconque des revendications précédentes, le couvercle de conception étant relié de manière amovible à l'élément de commande.

9. Élément de commande paramétrable selon l'une quelconque des revendications précédentes, comprenant en outre un ressort métallique, le ressort métallique étant configuré pour fixer l'élément de commande à un insert encastré, le ressort métallique comprenant des barbes et étant configuré pour empêcher le retrait de l'élément de commande de l'insert encastré.

10. Ensemble de commutation comprenant :
- l'élément de commande paramétrable selon l'une quelconque des revendications précédentes ;
- un cadre configuré pour accueillir l'élément de commande paramétrable de telle sorte qu'un écart entre l'élément de commande paramétrable et le cadre est configuré pour être éclairé par le guide de lumière.

11. Procédé de paramétrage pour paramétrer un élément de commande (300) selon l'une quelconque des revendications 1 à 9, le procédé comprenant :
- la réception par l'interface utilisateur d'un paramétrage du capteur de surface capacitif, le paramétrage comprenant au moins une fonction d'opération ;
- le paramétrage par l'unité logique du capteur de surface capacitif en fonction du paramétrage de sorte que le capteur de surface capacitif soit configuré pour détecter une entrée utilisateur à l'au moins une fonction d'opération et que l'unité logique soit configurée pour convertir l'entrée utilisateur à l'au moins une fonction d'opération en un signal de commande de l'au moins une installation de bâtiment.
